# EUROPÄISCHE PATENTSCHRIFT

(11) **EP 3 824 698 B1**
(45) Veröffentlichungstag und Bekanntmachung des Hinweises auf die Patenterteilung: **31.08.2022**
(21) Anmeldenummer: 19734230.6
(22) Anmeldetag: 24.05.2019
(51) Int. Cl.: H05K 7/14, H05K 7/20, H02M 7/00

(54) **LEISTUNGSBAUGRUPPE MIT TRAGENDEM KÜHLKÖRPER**
POWER MODULE COMPRISING A SUPPORTING COOLING BODY
MODULE DE PUISSANCE DOTÉ D'UN DISSIPATEUR THERMIQUE

(30) Priorität: 25.05.2018 AT 504282018; 25.05.2018 AT 504292018; 25.05.2018 AT 504302018; 25.05.2018 AT 504312018; 13.09.2018 AT 507862018
(43) Veröffentlichungstag der Anmeldung: 26.05.2021
(73) Patentinhaber: Miba Energy Holding GmbH, 4663 Laakirchen (AT)
(72) Erfinder: NAGELMÜLLER, Martin, 4650 Edt bei Lambach (AT); RATZI, Raimund, 4600 Wels (AT)
(74) Vertreter: Burger, Hannes
(86) Internationale Anmeldenummer: PCT/AT2019/060174
(87) Internationale Veröffentlichungsnummer: WO 2019/222783

(56) Entgegenhaltungen:
- US-A1- 2010 321 896

## Beschreibung

Die Erfindung betrifft eine Leistungsbaugruppe für einen Mittel- oder Hochspannungsumrichter, vorzugsweise einen Modularen Multilevel Umrichter (MMC), welche eine als Kühlplatte ausgebildete Kühlvorrichtung umfasst die zumindest einen Stützbereich zum Lastabtrag der Leistungsbaugruppe auf ein Gestell des Mittel- oder Hochspannungsumrichters aufweist. Die Erfindung betrifft ferner einen Mittel- oder Hochspannungsumrichter mit einer entsprechend ausgebildeten Leistungsbaugruppe.

Moderne Mittel- oder Hochspannungsumrichter weisen in der Regel eine Mehrzahl von miteinander verschalteten Leistungsbaugruppen, wie etwa MMC-Submodulen, zum Umrichten einer Wechsel- in eine Gleichspannung oder umgekehrt auf. Derartige Leistungsbaugruppen können auch als Submodule, speziell bei Modularen Multilevel Umrichtern, bezeichnet werden. Dabei sind dem Fachmann eine Vielzahl von möglichen Anordnungen von Energiespeicherbaugruppen, Leistungshalbleiterbaugruppen, damit verbundene Steuervorrichtungen und insbesondere zur Kühlung dieser Elemente vorgesehene Kühlvorrichtungen bekannt.

In der WO2008/074274A1 ist ein Multilevel-Stromrichter mit einer Mehrzahl von Leistungshalbleiter aufweisenden Stromrichtermodulen und einer Mehrzahl von Energiespeichern offenbart, wobei zumindest ein Stromrichtermodul an einem Energiespeicher tragend befestigt ist. Zur Ausbildung des Modularen Multilevel Umrichters werden derartige Multilevel-Stromrichter in einem Gestell derart angeordnet, dass der Energiespeicher auf Querstreben des Gestells an seiner Front- und Rückseite abgestützt ist. Ein schneller Austausch der Leistungsbaugruppe wird dadurch erschwert, dass die stehend angeordnete Leistungsbaugruppe relativ umständlich angehoben und aus bzw. in das Gestell transferiert werden muss. Bei einer derartigen Anordnung sind ferner zur Kontaktierung der Anschlüsse für Strom-, Steuerung- und/oder Kühlmittel teils relativ lange Verbindungselemente bzw. -leitungen erforderlich, welche nutzerseitig eine Beeinträchtigung der Zugänglichkeit mit sich bringen.

In der US2017194878A1 wird ein möglicher Aufbau für eine Leistungsbaugruppe bzw. Submodul eines Multilevel-Stromrichters offenbart, welcher die Anordnung einer Leistungshalbleiterbaugruppe der Leistungsbaugruppe zumindest teilweise direkt oder indirekt auf einer Kühlplatte vorsieht. Zur Montage einer derartigen Leistungsbaugruppe in einem Multilevel-Stromrichter ist jedoch eine relativ aufwändige Rahmenkonstruktion zur Halterung der einzelnen Komponenten der Leistungsbaugruppe erforderlich um eine Lastabtragung auf ein Gestell eines Multilevel-Stromumrichters zu ermöglichen. Des Weiteren weist die offenbarte Konstruktion den Nachteil auf, dass die Energiespeichereinheit in Vertikalrichtung auf der Halbleitereinheit angeordnet ist, wodurch die Kühlwirkung der Kühlplatte auf die Energiespeichereinheit reduziert wird.

Die EP1125355B1 offenbart eine Stromrichter-Kondensatorbaugruppe, welche als tragende Komponente ausgebildet ist. Die Kondensatoren sind oberhalb von Leistungshalbleitern montiert, wodurch der Nachteil einer reduzierten Wärmeableitung des entfernt von den Kondensatoren angeordneten Kühlkörpers in Kauf genommen werden muss.

Die US 2010/321896 A1 offenbart eine elektrische Leistungskomponente, die an einem Chassis einer elektrischen Leistungsvorrichtung angebracht ist, einschließlich eines Halbleiterelements, das eine elektronische Schaltung bildet, und einer Kühleinheit mit einer planaren Form, die das Halbleiterelement kühlt und welche Kühleinheit durch mehrere Schraubverbindungen mit einem Chassis zugleich als Verstärkungsmaterial zur Erhöhung der Festigkeit des Chassis dient.

Dem Fachmann sind weitere Anordnungen für Leistungsbaugruppen bekannt, in welchen die Energiespeicherbaugruppe in Längsrichtung hinter der Halbleiter- und/oder Steuerbaugruppe angeordnet ist. Vorrangig ist dabei die größte Längen-ausdehnung einer Leistungsbaugruppe in Vertikalrichtung ausgebildet, wodurch sich mehrere Leistungsbaugruppen in einem Gestell zur Bildung eines modularen Umrichters neben- und übereinander anordnen lassen, jedoch eine relativ hoch liegende Schwerpunktlage in Kauf genommen werden muss.

Die zunehmenden Anforderungen an die Sicherheit, insbesondere Explosionsschutz, Bedienersicherheit und elektromagnetische Verträglichkeit (EMV), gehen mit der Forderung einer kostengünstigen Fertigung der Leistungsbaugruppe einher. Des Weiteren ist eine schnelle und komfortable Austauschbarkeit einer Leistungsbaugruppe im Schadensfall wünschenswert. Außerdem wäre eine individuelle Anpassbarkeit einer Leistungsbaugruppe an die jeweiligen, lokalen Erfordernisse eines Mittel- oder Hochspannungsumrichters an stationären Anlagen wünschenswert, oder auch für den Einsatz an beweglichen Aufstellungsorten, wie etwa einem Zug oder Schiff, von praktischem Vorteil.

Aufgabe der vorliegenden Erfindung war es, die Nachteile des Standes der Technik zu überwinden und eine Leistungsbaugruppe zur Verfügung zu stellen, welches eine einfache, kostengünstige, sichere und schnell austauschbare Plattformlösung darstellt. Eine weitere Aufgabe der Erfindung war es eine gute Wärmeabfuhr zu gewährleisten und die EMV der Leistungsbaugruppe bzw. des Mittel- oder Hochspannungsumrichters zu verbessern.

Diese Aufgabe wird durch eine Leistungsbaugruppe und einen Mittel- oder Hochspannungsumrichter gemäß den Ansprüchen gelöst.

Die erfindungsgemäße Leistungsbaugruppe für einen Mittel- oder Hochspannungsumrichter, vorzugsweise einen Modularen Multilevel Umrichter, umfasst zumindest eine Leistungshalbleiterbaugruppe, zumindest eine Energiespeicherbaugruppe und zumindest eine Kühlvorrichtung. Die Kühlvorrichtung ist als, von einem Kühlmittel durchströmbare, insbesondere einer Kühlflüssigkeit durchfließbare, Kühlplatte ausgebildet, welche eine verglichen zu einer Kühlplattenlänge und einer Kühlplattenhöhe geringere Kühlplattendicke aufweist und zum Lastabtrag der Leistungsbaugruppe auf ein Gestell des Mittel- oder Hochspannungsumrichters zumindest einen, durch die Kühlplattenlänge und Kühlplattendicke und/oder einem Teil der Kühlplattenhöhe der Kühlplatte definierten, Stützbereich aufweist.

Durch die erfinderische Ausbildung der Leistungsbaugruppe, insbesondere der Kühlvorrichtung als lastabtragendes Konstruktionselement, wird gleichzeitig eine Stützfunktion der Leistungsbaugruppe am Gestell ausgeübt und eine Aufnahmeplattform für sämtliche am Kühlkörper angeordneten Baugruppen gebildet. Die Kühlplatte dient somit als eine Art Aufbauplatte zur Aufnahme der Energie-, Leistungshalbleiterbaugruppen und etwaiger weiterer Komponenten. Derartige Komponenten können z.B. in Form einer Hilfsbaugruppe an der Kühlplatte angeordnet sein und etwa eine Steuervorrichtung, Netzteile, Bypass-Schaltungen, Widerstände und dergleichen umfassen.

Die Leistungshalbleiterbaugruppe umfasst vorzugsweise eine IGBT-Baugruppe, MOSFETs, Transistoren oder dergleichen. Die Energiespeicherbaugruppe umfasst vorzugsweise eine Kondensatorbaugruppe, welche eine Mehrzahl von Kondensatoren umfassen kann, und/oder andere zweckdienliche Energiespeicher. Die Verbindung der einzelnen Komponenten mittels geeigneter Leitungselemente, wie Stromschienen, Kabeln oder dergleichen, ist dem Fachmann hinreichend bekannt und wird daher nicht näher erläutert.

Eine derartige Leistungsbaugruppe weist somit eine im Wesentlichen vertikal ausgerichtete Kühlplatte auf, welche sich in zumindest einem Stützbereich am Gestell lastübertragend abstützt. Der Stützbereich kann im Bereich einer Kühlplattenoberseite und/oder Kühlplattenunterseite vorgesehen sein, wodurch sich für den Fachmann anwendungsspezifische Vorteile ergeben, welche z.B. in einer sehr platzsparenden Anordnung mehrerer Leistungsbaugruppen in einem Gestell und/oder eines Aufnahmeraums des Gestells ähnlich eines "Steckkartenprinzips" ergeben. Die Längenausdehnung der Leistungsbaugruppe ist im Wesentlichen durch die Kühlplattenlänge vorgegeben und in Längsrichtung wesentlich größer als in Vertikal- und/oder Querrichtung. Durch geeignete Anordnung der elektrischen Komponenten der Leistungsbaugruppe, insbesondere der zumindest einen Energiespeicherbaugruppe, kann die Lage des Schwerpunkts relativ niedrig gewählt werden.

Die Lehre der vorliegenden Erfindung kann vom Fachmann auch im Bedarfsfall auf den Niederspannungsbereich übertragen werden.

Besonders vorteilhaft hat sich erwiesen, dass die Kühlplatte ein Verhältnis der Kühlplattenlänge in Längsrichtung zur Kühlplattenhöhe in Vertikalrichtung von 5:1 bis 1:2, insbesondere von 2:1 bis 1:1 aufweist und dabei jeweils größer ist als die Leistungsbaugruppenhöhe in Querrichtung. Hierdurch kann die Gefahr des Verkippens der Leistungsbaugruppe bei Wartungsarbeiten oder einem Wechsel wesentliche reduziert und dennoch eine sehr kompakte Leistungsbaugruppe realisiert werden.

Ein erfindungsgemäßer Mittel- oder Hochspannungsumrichter, vorzugsweise ein Modularer Multilevel Umrichter, umfasst zumindest eine Leistungsbaugruppe, wie oben sowie nachfolgend beschrieben, und zumindest ein Gestell mit einer Mehrzahl von Vertikalstehern und Horizontalträgern, welche zur Verbindung jeweils zumindest zweier Vertikalsteher angeordnet sind, und welches Gestell zumindest einen Aufnahmeraum für zumindest eine Leistungsbaugruppe aufweist, wobei zumindest ein Längsträger zum Lastabtrag der Leistungsbaugruppe zumindest zwei Horizontalträgern verbindend angeordnet ist.

Dies erlaubt eine relativ "schlanke" und materialsparende Bauweise des Gestells ohne die Stabilität zu beeinträchtigen. Die Längsträger sind dabei zum Lastabtrag zumindest einer Leistungsbaugruppe ausgelegt. Auf diese Weise üben die Längsträger gleichzeitig eine tragende Funktion für die Leistungsbaugruppe, sowie eine verbindende Funktion für die Horizontalträger des Gestells aus. Es kann auch vorgesehen sein, dass mehrere Leistungsbaugruppen in einem gemeinsamen Aufnahmeraum angeordnet sind, wodurch sich Ersparnisse hinsichtlich Kosten und/oder Platzbedarf ergeben können.

Des Weiteren kann es zweckmäßig sein, wenn zumindest ein Horizontalträger und/oder Längsträger aus einem elektrisch isolierenden Werkstoff, bevorzugt einem Glasfaserverbundwerkstoff, hergestellt sind.

Auf diese Weise kann eine Isolation der einzelnen Leistungsbaugruppen voneinander durch das Gestell bewerkstelligt werden, was in einem Kurzschlussfall zu einer Erhöhung der Sicherheit beiträgt. Es kann aus Kostengründen angedacht sein, die Vertikalsteher aus einem anderen, ggf. elektrisch leitfähigen Konstruktionswerkstoff auszubilden, da die Isolation maßgeblich durch die Längs- und/oder Horizontalträger bestimmt werden kann.

In nachfolgend eingehend diskutierten möglichen Anordnungen der Komponenten der Leistungsbaugruppe kann die Lage des Schwerpunkts durch geeignete Ausführung des Stützbereichs der Kühlplatte optimiert werden. Dabei kann der Lastabtrag erfindungsgemäß durch Abstützung der Kühlplatte an zumindest einem Stützbereich nach unten und/oder in einer Art hängenden Anordnung realisiert werden, wodurch sich für den Fachmann ein großer Gestaltungsfreiraum ergibt. Ferner kann durch die erfindungsgemäß ausgebildete Leistungsbaugruppe eine gute thermische Anbindung der wärmeabgebenden Komponenten an die Kühlplatte erzielt werden, sowie eine Homogenisierung der elektrischen Leitungspfade erreicht werden wodurch die EMV verbessert werden kann.

Ferner kann vorgesehen sein, dass der zumindest eine Stützbereich zum abstützenden Lastabtrag auf das Gestell in Vertikalrichtung im Wesentlichen nach unten als Stützfläche, bevorzugt zumindest die Kühlplattenlänge und Kühlplattendicke umfassend, ausgebildet ist.

Der Stützbereich kann im Bereich der Unterseite der Kühlplatte somit die Grundfläche der Kühlplatte nach unten, sowie einen in Vertikalrichtung anschließenden Teil der Seitenflächen, miteinschließen. Bevorzugt ist die Stützfläche über die gesamte Kühlplattenlänge erstreckt, wodurch die Flächenlast der Leistungsbaugruppe am Längsträger lokal verringert werden kann. Der bevorzugt flächige Lastabtrag der Leistungsbaugruppe über die Stützfläche ermöglicht eine sehr stabile Lage und/oder Führung, sowie ein relativ einfaches Handling der Leistungsbaugruppe.

Darüber hinaus kann vorgesehen sein, dass der zumindest eine Stützbereich zum Lastabtrag auf das Gestell im Bereich einer Kühlplattenoberseite der Kühlplatte, bevorzugt umfassend zumindest die Kühlplattenlänge und einen Teil der Kühlplattenhöhe, ausgebildet ist.

Eine derartige Ausbildung des Stützbereichs kann eigenständig oder auch in Verbindung mit zuvor genannter Stützfläche an einer Leistungsbaugruppe realisiert sein. Ein Stützbereich an der Kühlplattenoberseite kann somit dazu genutzt werden den Lastabtrag an einen in Vertikalrichtung darüber angeordneten Längsträger durchzuführen. Der Lastabtrag kann mittels geeigneter Rollkörper und/oder Gleitelementen zur Ausbildung einer Art "hängenden Leistungsbaugruppe" erfolgen, wodurch die Lage des Schwerpunkts der Leistungsbaugruppe in Vertikalrichtung von untergeordneter Bedeutung ist und eine stabile Halterung im Gestell erreicht werden kann.

Vorteilhaft ist auch, dass die Kühlplatte an beiden, durch die Kühlplattenlänge und die Kühlplattenhöhe der Kühlplatte definierte, Seiten zumindest eine Aufnahmefläche, zur Anordnung jeweils zumindest einer Leistungshalbleiterbaugruppe oder zumindest einer Energiespeicherbaugruppe, aufweist.

Derartige Aufnahmeflächen müssen dabei nicht über die gesamte Kühlplattenhöhe und/oder - länge erstreckt sein, sondern können jeweils nur einen Teil der Seitenflächen ausmachen. An diesen Aufnahmeflächen können die einzelnen elektrischen Komponenten, insbesondere die zumindest Energiespeicher- und/oder Leistungshalbleiterbaugruppe thermisch leitfähig direkt an der Kühlplatte angeordnet werden. Dies erlaubt eine hocheffiziente Wärmeabfuhr. Außerdem kann die Kühlplatte auf diese Weise dem Grundgedanken einer Aufbauplattform folgend bestmöglich genutzt werden.

Ebenso erlaubt diese Ausführungsform eine Vielzahl an möglichen Anordnungen um eine gute Gewichtsverteilung bzw. Schwerpunktlage einstellen zu können. Beispielhaft ist hierbei denkbar die zumindest eine Leistungshalbleiterbaugruppe sowie die zumindest eine Energiespeicherbaugruppe an einer Seite der Kühlplatte anzuordnen, oder auch an jeweils gegenüberliegenden Seiten der Kühlplatte. Ebenso sind Kombinationen von mehreren voneinander unabhängigen Energiespeicher- und/oder Leistungshalbleiterbaugruppen an einer gemeinsamen Kühlplatte vorstellbar, wodurch vereinfacht ausgedrückt die Möglichkeit geschaffen wird mehrere funktionelle Leistungsbaugruppen mittels einer gemeinsamen Kühlplatte auszubilden.

Gemäß einer Weiterbildung ist es möglich, dass die Kühlplatte zumindest eine Anschlussöffnung in Querrichtung zur Durchführung und Kontaktierung zumindest von Stromanschlüssen der zumindest einen Energiespeicherbaugruppe zur zumindest einen Leistungshalbleiterbaugruppe und/oder zumindest einer Hilfsbaugruppe aufweist.

Die Anschlussöffnung durchdringt die Kühlplatte dabei in Querrichtung. Auf diese Weise kann ein kompliziertes Herumführen der stromführenden Leitungen um die Kühlplatte herum effizient vermieden werden. Durch eine derartige Anschlussöffnung können somit sehr kurze elektrischen Leitungspfade erzielt werden, wodurch eine Homogenisierung von kapazitiven und/oder induktiven Störungen bis hin zu deren Vermeidung erreicht werden kann. Dies begünstigt die elektromagnetische Verträglichkeit der Leistungsbaugruppe bzw. des Mittel- oder Hochspannungsumrichters. Die Anordnung dieser zumindest einen Anschlussöffnung kann bedarfsgemäß an der Kühlplatte gewählt werden, ist jedoch bevorzugt in Vertikalrichtung mittig positioniert.

Ferner ist die zumindest eine Leistungshalbleiterbaugruppe an der ersten Seite und die zumindest eine Energiespeicherbaugruppe an der, der ersten Seite gegenüberliegenden, zweiten Seite der Kühlplatte angeordnet.

Unter Einbezug der obigen Diskussion kann mit dieser Ausführungsform eine örtliche Trennung der Energiespeicherbaugruppe von der Leistungshalbleiterbaugruppe durchgeführt werden. Dies kann im Schadensfall einer Leistungsbaugruppe, welche durch fehlerhafte Leistungshalbleiter verursacht wird, besonders günstig sein. Häufig geht das Versagen eines oder mehrer Leistungshalbleiter bei hohen Spannungen in Mittel- oder Hochspannungsumrichter explosionsartig, sowie unter Druck-, Staub- und/oder Wärmeentwicklung, vonstatten. Durch die räumliche Trennung der zumindest einen Leistungshalbleiterbaugruppe von den übrigen elektrischen Komponenten durch die Kühlplatte kann ein Explosionsschutz realisiert werden und somit die Sicherheit im Betrieb verbessert werden.

Darüber hinaus kann vorgesehen sein, dass an der Kühlplatte zumindest ein mit einer Koppelvorrichtung des Gestells korrespondierendes Rückhalteelement angeordnet ist.

Das Rückhalteelement der Kühlplatte kann als Fortsatz, bevorzugt als Stift mit Nut oder Stift mit gegenüber einem Stiftdurchmesser verbreiterten Kopf, oder auch als Ausnehmung, bevorzugt als Kerbe, Nut, oder dergleichen, ausgebildet sein. Die Koppelvorrichtung am Gestell ist analog dazu, also insbesondere form- und funktionskomplementär, ausgebildet. Die Koppelvorrichtung kann dabei "aktiv", wie etwa über einen separaten Betätigungsmechanismus, oder auch "passiv", wie etwa als Einrastelement, ausgebildet sein. Auf diese Weise kann das zumindest eine Rückhalteelement als Zentrierhilfe und/oder Endanschlag in Längsrichtung dienen, wodurch Beschädigungen beim Wechsel vermieden werden können. Ebenso ist durch diese Ausführungsform eine selbsttätige, also "passive" und/oder "aktive" Arretierung der Leistungsbaugruppe im Gestell möglich, wodurch die Sicherheit vor Herausfallen und/oder Verkippen der Leistungsbaugruppe, wie z.B. bei einem Erdbeben, erhöht werden kann. Das Rückhalteelement ist bevorzugt an der Rückseite der Kühlplatte angeordnet.

Des Weiteren kann vorgesehen sein, dass die Leistungsbaugruppe zumindest ein Schutzgehäuse zur Aufnahme zumindest einer Leistungshalbleiterbaugruppe und/oder Hilfsbaugruppe und/oder Energiespeicherbaugruppe aufweist, welches mit der Kühlplatte befestigbar, bevorzugt koppelbar, ausgebildet ist.

Ein derartiges Schutzgehäuse kann die Sicherheit der darin aufgenommenen elektrischen Komponenten vor externen Einflüssen, wie Staub, Flüssigkeiten, etc. deutlich erhöhen. Ferner kann ein solches Schutzgehäuse aus mehreren Teilschutzgehäusen bestehen, welche unter Umständen unterschiedliche Höhen aufweisen. Dies ermöglicht einen Schutz im Schadens- bzw. Explosionsfall der einzelnen Komponenten und kann zudem eine sehr kompakte Bauweise der Leistungsbaugruppen erlauben.

Gemäß einer besonderen Ausprägung ist es möglich, dass zumindest ein Schottwandelement zumindest zwei Komponenten, wie etwa Leistungshalbleiterbaugruppe und/oder der Hilfsbaugruppe und/oder der Energiespeicherbaugruppe, voneinander trennend, sowie die Kühlplatte mit dem zumindest einen Schutzgehäuse verbindend angeordnet ist.

Durch die Trennung der Komponenten, insbesondere der Leistungshalbleitersektion von der Hilfsbaugruppe durch die Ausbildung der zumindest einen Schottwand kann ein Gas- und/oder Partikeleintritt im Explosionsfall in die Sektion einer benachbart angeordneten Komponente effizient verringert oder sogar ganz vermieden werden. Zweckmäßigerweise weist ein derartiges Schottwandelement formkomplementäre Durchgangsöffnungen für etwaige Strom- und/oder Steuer- und/oder Messanschlüsse bzw. -leitungen auf.

Entsprechend einer vorteilhaften Weiterbildung kann vorgesehen sein, dass zumindest zwei Stromanschlüsse und/oder Steueranschlüsse und/oder Kühlmittelanschlüsse und/oder etwaige Messanschlüsse und/oder Hilfsanschlüsse an einer Frontseite der Leistungsbaugruppe ausgebildet sind.

Durch diese Maßnahme wird eine sehr gute Zugänglichkeit zu den Anschlüssen der Leistungsbaugruppe für einen Bediener gewährleistet. Eine einfache, schnelle und sichere An- bzw. Abkopplung der Anschlüsse kann dadurch erreicht werden. Die Kühlmittelanschlüsse sind dabei bevorzugt als Schnellverschlüsse ausgebildet, wodurch die Geschwindigkeit beim Wechsel einer Leistungsbaugruppe erhöht werden kann.

Ebenso ist denkbar, dass zumindest zwei Stromanschlüsse und/oder Steueranschlüsse und/oder, bevorzugt als Schnellverschlüsse ausgebildete, Kühlmittelanschlüsse und/oder etwaige Messanschlüsse und/oder Hilfsanschlüsse an einer Rückseite der Leistungsbaugruppe ausgebildet sind.

Auf diese Weise kann ähnlich einem "Steckkartenprinzip" eines PCs die Leistungsbaugruppe in den Aufnahmeraum des Gestells hineinbewegt werden. Vorteilhafterweise ist die Kühlplatte hierbei in Längsrichtung zur Rückseite hin die elektrischen Komponenten bzw. deren Schutzgehäuse überragend ausgebildet. Die beispielhaft genannten Anschlüsse können zu einer an der Rückseite des Gestells angeordneten Versorgungsplattform komplementär ausgebildet sein, wodurch eine, bevorzugt selbsttätige, Kopplung und/oder Entkopplung erreicht werden kann. Dies erleichtert die Bedienung und kann die Betriebssicherheit erhöhen, da die fehlerhafte Bedienung von Anschlüssen vermieden werden kann.

Insbesondere kann es vorteilhaft sein, wenn an der Frontseite der Kühlplatte in Vertikalrichtung über die Kühlplattenhöhe zumindest ein hervorragendes Anschlagelement angeordnet ist.

Diese Maßnahme kann als Tiefenanschlag der Leistungsbaugruppe dienen und die korrekte Positionierung aller Anschlüsse in vorgebbarer bzw. definierter Lage sicherstellen. Zudem wird die Gefahr von Beschädigungen bei rückseitig angeordneten Anschlüssen effizient vermieden.

Ferner kann vorgesehen sein, dass die Kühlplatte aus zumindest zwei in Längsrichtung und/oder Querrichtung und/oder Vertikalrichtung geteilten, Kühlplattensegmenten zur Ausbildung eines durchgehenden Kühlkanals zusammengesetzt ist.

Eine Ausbildung der Kühlplatte durch Zusammensetzen mehrerer Kühlplattensegmente ermöglicht eine einfache modulare Bauweise der Kühlplatte, wodurch entsprechend des Plattformgedankens der vorliegenden Erfindung eine einfache bedarfsgemäße Anpassung an die Anordnung der Leistungshalbleiterbaugruppe und/oder der Energiespeicherbaugruppe an der Kühlplatte vorgenommen werden kann. In einfachsten Fall kann durch Zusammenfügen von zwei horizontal geteilten Kühlplattensegmenten eine Kühlplatte gebildet sein, wobei zumindest ein Kühlplattensegment eine Ausnehmung für einen Kühlkanal aufweist. Die Kühlplattensegmente können miteinander durch geeignete Verbindungselemente verbunden sein. Auch Lötverbindungen sind hierbei denkbar. Zur Erhöhung der Festigkeit können die Kühlplattensegmente mittels einer Schweißverbindung verbunden sein. Insbesondere bei Kühlplatten aus Aluminium oder Aluminiumlegierungen hat sich eine Verbindung der Kühlplattensegmente zueinander mittels Rührreibschweißens bewährt.

Darüber hinaus kann vorgesehen sein, dass zumindest zwei Kühlplattensegmente voneinander unterschiedliche Kühlleistungen aufweisen.

Auf diese Weise wird es möglich, eine Optimierung der lokalen Wärmeabfuhr durch die Kühlplatte vorzunehmen. Die zuvor beschriebenen Maßnahmen erlauben somit eine lokale Anpassung der Wärmeabfuhrleistung entsprechend der vorgebbaren Anordnung von insbesondere Leistungshalbleitern und/oder Energiespeicher an der Kühlplatte. Beispielsweise kann beim erfindungsgemäßen stehenden Aufbau der Kühlplatte eine höhere Wärmeabfuhr im Bereich von oberhalb der Energiespeicherbaugruppe angeordneten Leistungshalbleiterbaugruppen vorteilhaft sein, wodurch zudem die Schwerpunktlage vorteilhaft niedriger gewählt werden kann. Außerdem kann eine derartige Ausbildung der Kühlplatte zu einem kostengünstigen Design führen.

Darüber hinaus kann vorgesehen sein, dass zumindest ein Kühlplattensegment, zur Ausbildung eines durchgehenden Kühlkanals in zusammengesetztem Zustand der Kühlplatte, eine Kühlkanalausnehmung zur Aufnahme einer formkomplementären Kühlmittelleitung aufweist, welche in zusammengesetztem Zustand der Kühlplatte von der Kühlplatte eingeschlossen ist.

Vorteilhaft ist auch eine Ausprägung, gemäß welcher vorgesehen sein kann, dass die Kühlplatte zumindest in Vertikalrichtung relativ zur zumindest einen Leistungshalbleiterbaugruppe und/oder zumindest einen Energiespeicherbaugruppe und/oder zumindest einem Schutzgehäuse hervorragend ausgebildet ist.

Derartige hervorragende Vorsprünge können zu einer verbesserten Sicherheit bei der Längsbewegung der Leistungsbaugruppe beim Wechsel genutzt werden. Bevorzugt umfassen derartige Vorsprünge den zumindest einen Stützbereich und können gleichzeitig zur seitlichen Abstützung der Leistungsbaugruppe in Querrichtung an dafür vorgesehenen Führungselementen des Gestells dienen, wodurch die Stabilität der Lage der Leistungsbaugruppen erhöht werden kann.

Analog hierzu ist es möglich, dass zumindest ein Längsträger des Mittel- oder Hochspannungsumrichters zumindest ein Führungselement zur Führung und/oder Erhöhung der Lagestabilität der Kühlplatte, insbesondere des Stützbereichs, zumindest in Querrichtung aufweist.

Derartige Führungselemente können an einer Ober- und/oder Unterseite des Längsträgers angeordnet sein. Sie können zur seitlichen und/oder vertikalen Abstützung genutzt werden und erlauben einen schnellen und sicheren Wechsel der Leistungsbaugruppe.

Gemäß einer Weiterbildung ist es möglich, dass zumindest ein Führungselement zur Aufnahme des Stützbereichs und/oder zur Führung der Kühlplatte an einer Unterseite zumindest eines Längsträgers als Z-, L-, C- oder U-förmiges Profilelement ausgebildet ist.

Diese Maßnahme ist insbesondere im Falle einer unterseitigen Anordnung zum vertikalen Lastabtrag in das Gestell nützlich. Eine "hängende" Anordnung der Leistungsbaugruppe kann durch derartige Führungselemente einfach und kostengünstig realisiert werden. Es ist ebenso denkbar, dass derartige Führungselemente Rollkörper und/oder Gleitelemente aufweisen, welche eine Bewegung der Kühlplatte bzw. des Stützbereiches erleichtern.

Ferner kann es zweckmäßig sein, wenn die Kühlplatte im Stützbereich zumindest zwei Rollkörper aufweist. Die Rollkörper können an oder innerhalb der Kühlplatte oder einer dafür vorgesehenen Rollkörperaufnahme ausgebildet sein.

Durch eine Mehrzahl von Rollen im Stützbereich kann das Bewegen der Leistungsbaugruppe effektiv erleichtert werden, wodurch insbesondere die Sicherheit und Geschwindigkeit beim Wechsel erhöht werden können.

Es ist dabei möglich, dass die zumindest zwei Rollkörper an der Stützfläche der Kühlplatte angeordnet sind und bevorzugt in Vertikalrichtung gegenüber der Stützfläche zumindest teilweise hervorragbar verstellbar ausgebildet sein können.

Derartige Rollkörper, welche im Wesentlichen an der Unterseite der Kühlplatte angeordnet sind, sind gegenüber Verschmutzung und/oder Korrosion sehr gut geschützt. Es ist dabei bevorzugt möglich, dass die Rollkörper zwischen einer Servicestellung und einer Ruhestellung mittels einer in die Kühlplatte bzw. den Stützbereich integrierten Hebelmechanik verstellbar sind. Hierbei treten die Rollkörper in der Servicestellung über die Stützfläche hervor, wodurch eine Bewegung der Leistungsbaugruppe ermöglicht wird, während sie in der Ruhestellung hinter die Stützfläche zurück in die Kühlplatte versenkt werden können. Die Leistungsbaugruppe wird hierdurch als Ganzes in der Servicestellung leicht angehoben bzw. in der Ruhestellung durch die flächige Auflage der Stützfläche auf dem Führungselement und/oder dem Längsträger gegen Bewegung gesichert. Die Rollkörper sind von einander in Längsrichtung beabstandet im Inneren des Stützbereichs, also der Kühlplatte angeordnet. Die gemeinsame Verstellung der Rollkörper bzw. die Betätigung der Hebelvorrichtung kann z.B. über eine gemeinsame Koppelstange erfolgen und durch Aufbringen einer Kraft manuell oder auch motorisch durchgeführt werden.

Es ist auch möglich die zumindest zwei Rollkörper im Stützbereich seitlich, etwa an der ersten und/oder zweiten Seite der Kühlplatte, anzuordnen.

Derartig angeordnete Rollkörper können bevorzugt im Bereich der Kühlplattenoberseite im Stützbereich angeordnet sein, um z.B. eine "hängende" Anordnung der Leistungsbaugruppe zu realisieren. Hierbei verläuft die Rotationsachse der Rollkörper im Wesentlichen in Querrichtung. Dies kann eine eigenständige Lösung für eine reibungsarme Bewegung der Leistungsbaugruppe darstellen oder auch in Kombination mit zuvor genannten Ausführungsformen erfolgen. Ebenso können die Rollkörper auch mit ihrer Rotationsachse im Wesentlichen vertikal ausgerichtet sein, wodurch eine reibungsarme Führung im oder am Führungselement ermöglicht wird.

Um die Bewegung der Leistungsbaugruppe in einem Mittel- oder Hochspannungsumrichter zu ermöglichen kann erfindungsgemäß auch auf die Ausbildung von Rollkörpern als integraler Bestandteil der Kühlplatte verzichtet werden. Entsprechend einer vorteilhaften Weiterbildung ist dabei zumindest ein Längsträger des Gestells als Hohlkörper ausgebildet ist und weist zumindest zwei Durchtrittsöffnungen, zum Durchtritt jeweils zumindest eines Rollkörpers in einer Servicestellung eines in den Längsträger in einer Ruhestellung einführbaren Hebewerkzeugs, auf.

Das Funktionsprinzip des genannten Hebewerkzeugs kann analog zur obigen Beschreibung der verstellbaren Rollkörper der Kühlplatte angesehen werden, jedoch verbleiben in dieser Ausführungsform während des Betriebs keine Rollkörper innerhalb des Gestells. Die Durchtrittsöffnungen für die Rollkörper sind am Längsträger in Vertikalrichtung nach oben vorgesehen, wobei sich das Hebewerkzeug in Vertikalrichtung nach unten auf der Innenseite des Hohlkörpers abstützt. Erfindungsgemäß ist das Einführen nur eines Hebewerkzeugs ausschließlich im Schadens- oder Servicefall in den dafür vorgesehenen Hohlkörper erforderlich. Dies vermeidet die Anordnung beweglicher und/oder loser Teile im Gestell, welche sich insbesondere bei Hochspannungsanwendungen als nachteilig erweisen können. Zudem tritt durch die Vermeidung von bekannten Anhebevorrichtungen bzw. Rollladensystemen an jedem einzelnen Aufnahmeraum des Gestells eine Reduktion des Gesamtgewichts des Mittel- oder Hochspannungsumrichters ein. Überdies ist lediglich ein Hebewerkzeug für den Service eines Mittel- oder Hochspannungsumrichters erforderlich, wodurch Anschaffungskosten entfallen. Ein derartiges Hebewerkzeug kann ebenso manuell und/oder motorisch betrieben werden um die Rollkörper von der Ruhestellung in die Servicestellung und retour zu verstellen. Zum besseren Verständnis der Erfindung wird diese anhand der nachfolgenden Figuren näher erläutert.

Es zeigen jeweils in stark vereinfachter, schematischer Darstellung:
- Fig. 1: schematische Schrägansicht einer Leistungsbaugruppe in einem Mittel- oder Hochspannungsumrichter;
- Fig. 2: schematische Frontansicht verschiedener möglicher Anordnungen von Energiespeicherbaugruppen und Leistungshalbleitergruppen an der Kühlplatte der Leistungsbaugruppe (a) bis (c);
- Fig. 3: schematische Explosionsdarstellung einer möglichen Ausführungsform einer Leistungsbaugruppe;
- Fig. 4: schematische Schrägansicht einer Leistungsbaugruppe mit Rückhalteelement und korrespondierender Koppelvorrichtung am Gestell;
- Fig. 5: schematische Explosionsdarstellung einer Kühlplatte aus mehreren Kühlplattensegmenten mit unterschiedlichen Kühlleistungen;
- Fig. 6: schematische Darstellung eines Ausschnitts des Stützbereichs einer Kühlplatte mit verstellbaren Rollkörpern in der Ruhestellung (a) bzw. Servicestellung (b);
- Fig. 7: schematische Schnittdarstellung einer Leistungsbaugruppe in hängender und/oder stehender Abstützung am Gestell (a,b), sowie schematische Schrägansicht eines Ausschnitts des Gestells mit in den Längsträger einführbarem Hebewerkzeug (c).

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

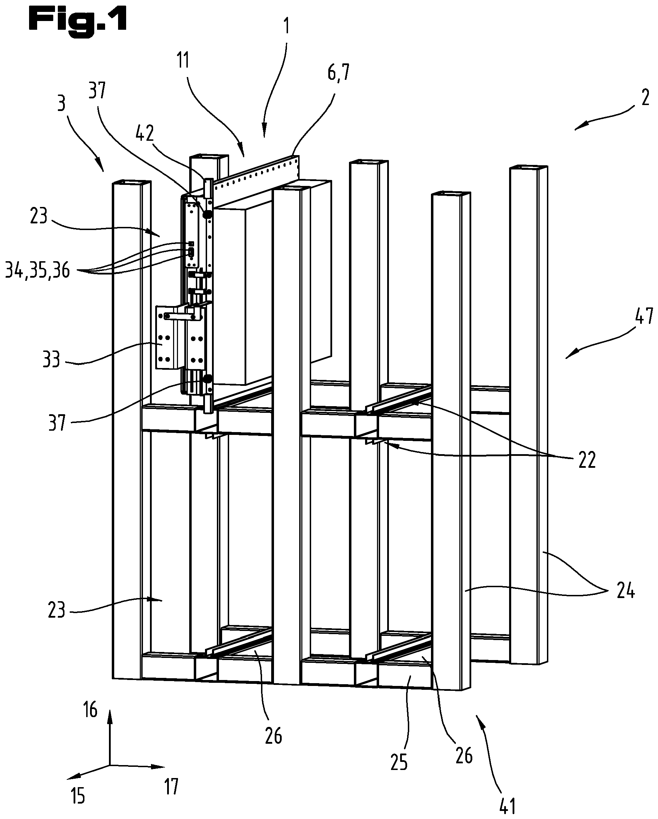

In Fig. 1 ist eine schematische Darstellung eines Mittel- oder Hochspannungsumrichters 2 mit einer erfindungsgemäßen Leistungsbaugruppe 1 dargestellt. Das erfindungsgemäße Konzept kann auch für Niederspannungsumrichter angedacht werden. Der Mittel- oder Hochspannungsumrichter 2 weist ein Gestell 3 auf, welches eine Mehrzahl von Vertikalstehern 24 und Horizontalträgern 25 umfasst. Die Horizontalträger 25 sind zur Verbindung jeweils zumindest zweier Vertikalsteher 24 angeordnet. Das Gestell 3 weist eine Mehrzahl von Aufnahmeräumen 23 auf, welche zur Aufnahme jeweils zumindest einer Leistungsbaugruppe 1 ausgebildet sind. Die front- bzw. rückseitig angeordneten Horizontalträger 25 sind mittels Längsträgern 26 verbunden. Die Längsträger 26 dienen zum Lastabtrag der Leistungsbaugruppe 1 und können an der Oberseite und/oder Unterseite ein oder mehrere Führungselemente 22 aufweisen.

Weiters ist aus Fig. 1 ersichtlich, dass die erfindungsgemäße Leistungsbaugruppe 1 eine Kühlvorrichtung 6 in Form einer lastabtragenden Kühlplatte 7 aufweist. Die Kühlplatte 7 weist verglichen zu ihrer Kühlplattenlänge 8 und der Kühlplattenhöhe 9 in Querrichtung 17 eine geringere Kühlplattendicke 10 auf. Die Kühlplatte 7 ist zum Lastabtrag der Leistungsbaugruppe 1 auf das Gestell 3 derart ausgebildet, dass der Lastabtrag an zumindest einem Stützbereich 12 der Kühlplatte erfolgen kann.

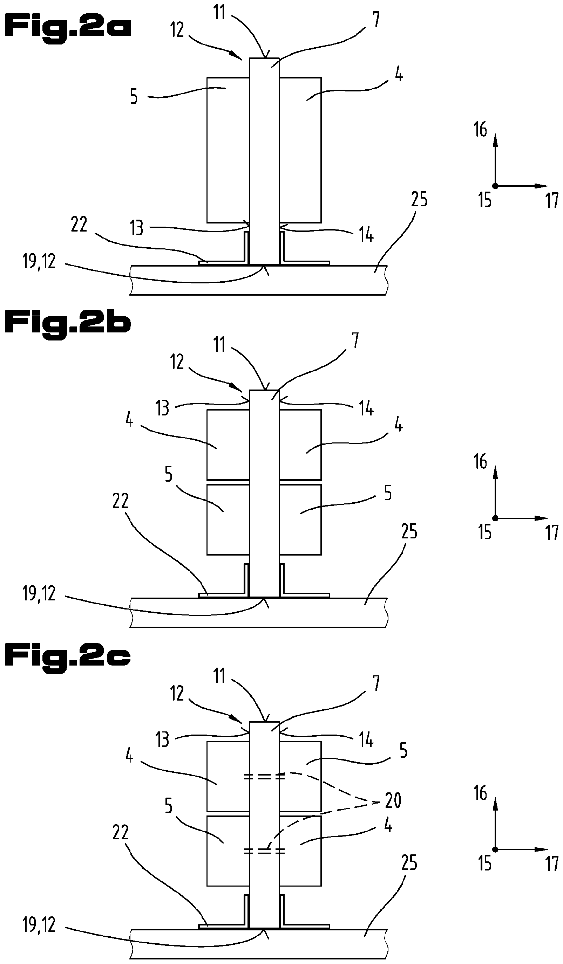

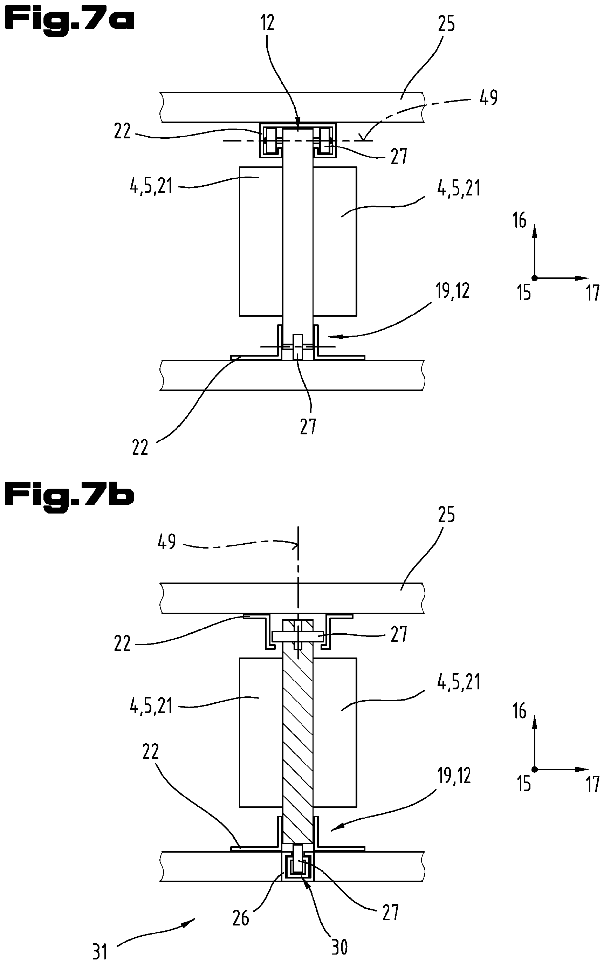

Das Wirkprinzip des Lastabtrags der Leistungsbaugruppe 1 über den zumindest einen Stützbereich 12 auf das Gestell 3 kann besonders gut in Zusammenschau mit Fig. 2a bis c sowie Fig. 7a und b ersehen werden. Aus Fig. 1 kann weiter ersehen werden, dass zumindest zwei Stromanschlüsse 33 und/oder Steueranschlüsse 36 und/oder Kühlmittelanschlüsse 37 und/oder etwaige Messanschlüsse 34 und/oder Hilfsanschlüsse 35 an der Frontseite 41 der Leistungsbaugruppe 1 ausgebildet sein können. Der Kürze halber nicht dargestellt ist die Situation in welcher ein Teil oder sämtliche der zuvor genannten Anschlüsse an der Rückseite 47 der Leistungsbaugruppe ausgebildet sein können.

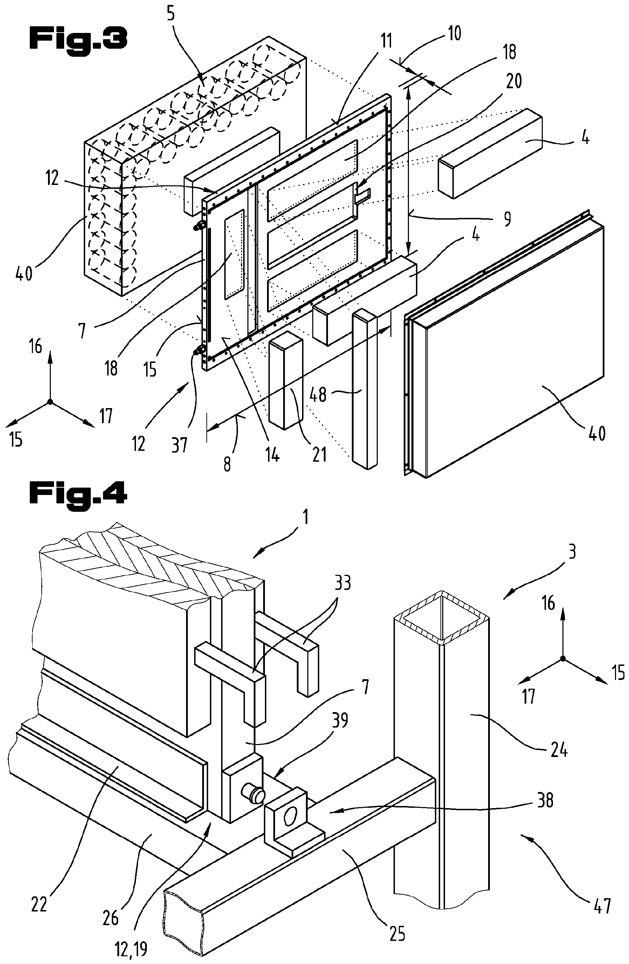

In Fig. 2a bis c sind unterschiedliche mögliche Ausführungsformen für Anordnungen der zumindest einen Leistungshalbleiterbaugruppe 4 sowie der zumindest einen Energiespeicherbaugruppe 5 an der Kühlplatte 7 schematisch dargestellt, obwohl auch eine einseitige Anordnung aller Komponenten grundsätzlich möglich ist. In Zusammenschau mit Fig. 3 wird klar ersichtlich, dass eine erste und zweite Seite 13,14 der Kühlplatte 7 durch die Kühlplattenlänge 8 und die Kühlplattenhöhe 9 definiert sind. An diesen ersten und zweiten Seiten 13,14 können zumindest eine Aufnahmefläche 18 zur Anordnung jeweils zumindest einer Leistungshalbleiterbaugruppe 4 und/oder zumindest einer Energiespeicherbaugruppe 5 vorgesehen sein. Ebenso können weitere Komponenten, wie etwa eine oder mehrere Hilfsbaugruppen 21 an den Seiten 13,14 der Kühlplatte angeordnet sein.

In Fig. 2a ist eine Situation schematisch dargestellt, in welcher die Energiespeicherbaugruppe 5 an einer ersten Seite 13 der Kühlplatte 7 angeordnet ist und eine Leistungshalbleiterbaugruppe 4 an der gegenüberliegenden zweiten Seite 14 angeordnet ist.

Fig. 2b ist eine weitere mögliche Ausführungsform dargestellt, in welcher jeweils eine Leistungshalbleiterbaugruppe 4 sowie eine Energiespeicherbaugruppe 5 an einer ersten und zweiten Seite 13,14 der Kühlplatte 7 angeordnet sind.

In Fig. 2c ist eine weitere mögliche Ausführungsform dargestellt, wobei zu einander korrespondierende Leistungshalbleiterbaugruppen 4 und Energiespeicherbaugruppen 5 an gegenüberliegenden Seiten der Kühlplatte 7 angeordnet sind und jeweils durch eine Anschlussöffnung 20 miteinander verbunden sind.

Zur Verbindung der Energiespeicherbaugruppen 5 zu korrespondierenden Leistungshalbleiterbaugruppen 4 kann es vorteilhaft sein, Anschlussöffnungen 20 vorzusehen, wie insbesondere aus Fig. 3, und in Fig. 2c strichliert dargestellt, ersichtlich. Die in Fig. 2a bis c dargestellten Ausführungsformen stellen einen Lastabtrag der Leistungsbaugruppe 1 über einen Stützbereich 12 dar, welcher an der Unterseite der Kühlplatte 7 als Stützfläche 19 ausgebildet ist. Alternativ dazu oder in Kombination sei auf die Diskussion der Fig. 7a bis c verwiesen.

Fig. 3 stellt schematisch eine Explosionsdarstellung eines Ausführungsbeispiels einer erfindungsgemäßen Leistungsbaugruppe 1 dar. Wie dargestellt, können mehrere Leistungshalbleiterbaugruppen 4 sowie eine oder mehrere Energiespeicherbaugruppen 5 an dafür vorgesehenen Aufnahmeflächen 18 angeordnet sein. Die Verbindung zwischen diesen Komponenten und/oder einer Hilfsbaugruppe 21 kann die Kühlplatte 7 durchdringend über dafür vorgesehene Anschlussöffnungen 20 vorgenommen werden. Ebenso ist aus Fig. 3 ersichtlich, dass ein oder mehrere Schutzgehäuse 40 zur Aufnahme zumindest einer Leistungshalbleiterbaugruppe 4 und/oder etwaiger weiterer Komponenten mit der Kühlplatte 7 befestigbar ausgebildet ist. Die Leistungsbaugruppe 1 kann demnach ein oder mehrere Schutzgehäuse 40 aufweisen.

Ferner ist aus Fig. 3 eine bevorzugte Maßnahme ersichtlich, welche die Ausbildung eines Schottwandelements 48 zwischen zwei Komponenten an einer Seite der Kühlplatte 7 aufzeigt. Das Schottwandelement 48 trennt beispielhaft die Leistungshalbleiterbaugruppen 4 von der Hilfsbaugruppe 21 und verbindet die Kühlplatte 7 mit den einteilig ausgebildeten Schutzgehäuse 40. Die Verbindung des Schottwandelements 48 und/oder des Schutzgehäuses 40 zur Kühlplatte 7 kann bevorzugt über Schraubverbindungen vorgenommen werden. Es können auch mehrere derartige Schottwandelemente 48 an einer ersten und/oder zweiten Seite 13,14 der Kühlplatte 7 vorgesehen sein.

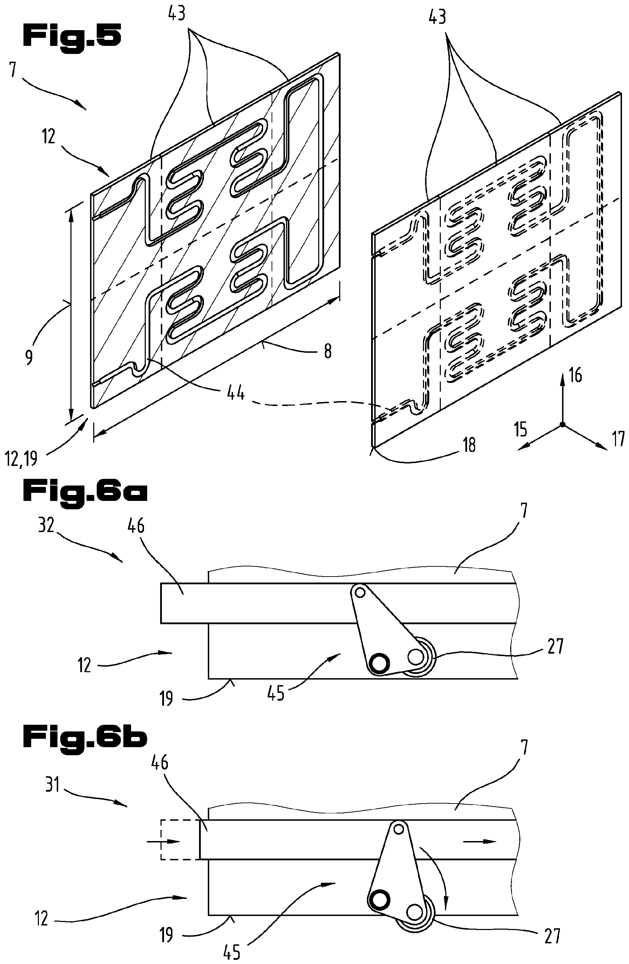

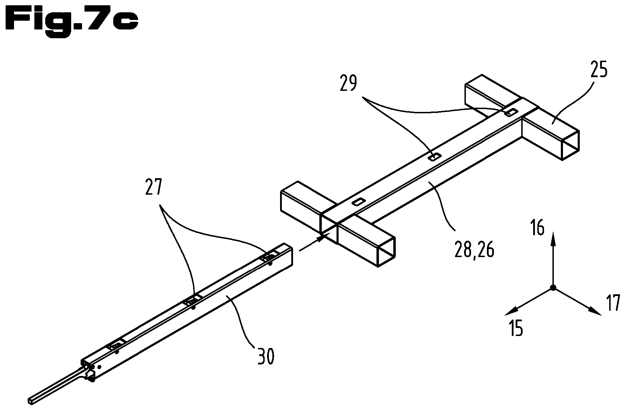

In Fig. 4 ist eine beispielhafte Ausführungsform eines an der Kühlplatte 7 angeordneten Rückhalteelements 39 gezeigt, welches mit einer Koppelvorrichtung 38 des Gestells 3 korrespondierend ausgebildet ist. Im gezeigten Ausführungsbeispiel ist das Rückhalteelement 39 als stiftförmiger Fortsatz mit einem gegenüber dem Stiftdurchmesser verbreiterten Kopf dargestellt, welcher selbsttätig mit einer laschenförmig ausgebildeten Koppelvorrichtung 38 beim Absenken der Leistungsbaugruppe 1 aus der Servicestellung 31 in die Ruhestellung 32 arretiert. Für die Diskussion der Funktionsweise der Anhebung in die Servicestellung 31 bzw. Absenkung in die Ruhestellung 32 sei auf die Diskussion der Fig. 6 und 7c verwiesen.

Aus Fig. 4 kann ferner ersehen werden, dass die Leistungsbaugruppe 1 im Stützbereich 12 entlang des Längsträgers 26 geführt ist. Die dargestellten Führungselemente 22 sowie das Rückhalteelement 39 können unter anderem als Zentrierhilfe genutzt werden. Vorteilhafterweise ist die Koppelvorrichtung 38 am Horizontalträger 25 angeordnet. Das Rückhalteelement 39 in der gezeigten Form, oder auch einer funktionsgleichen Ausführung, kann auch als eine Art Endanschlag dienen um eine Beschädigung rückseitig angeordneter Anschlüsse zu vermeiden. Alternativ oder in Ergänzung können auch ein oder mehrere Anschlagelemente 42, wie in Fig. 1 dargestellt, an der Kühlplatte 7 angeordnet sein.

In Fig. 4 sind, nicht dargestellt, etwaige Rückhalteelemente, welche z.B. als Ausnehmungen und/oder seitlich an der Kühlplatte 7 hervorragende Fortsätze ausgeführt sind. Die formkomplementären Koppelvorrichtungen 38 können in diesem Fall aktiv durch einen Bediener zu betätigen oder auch selbsttätig zu einem Arretieren bzw. Freigeben der Leistungsbaugruppe 1 ausgebildet sein.

In Fig. 4 sind beispielhaft Stromanschlüsse 33 angedeutet, welche stellvertretend für Steueranschlüsse 36, Kühlmittelanschlüsse 37 und dergleichen an der Rückseite 47 der Leistungsbaugruppe 1 angeordnet sein können. Aus dieser Darstellung ist einfach vorstellbar, dass beim Hineinbewegen der Leistungsbaugruppe 1 in Längsrichtung 15 eine Kopplung dieser Anschlüsse mit einer nicht dargestellten Versorgungsplattform erfolgen kann.

In Fig. 5 ist eine schematische Explosionsansicht einer möglichen Ausführungsform einer durch Kühlplattensegmente 43 gebildeten Kühlplatte 7 ersichtlich. Wie dargestellt, können die Kühlplattensegmente 43 über unterschiedlich angeordnete Kühlkanäle 44 verfügen, welche durch Zusammensetzen der Kühlplattensegmente 43 einen geschlossenen Kühlkanal 44 ausbilden. Wie aus dieser schematischen Darstellung ersichtlich, kann die Ausbildung der Kühlplatte 7 durch Zusammensetzen mehrere Kühlplattensegmente 43 vorgenommen werden. Auf diese Weise können sehr einfach lokal unterschiedliche Kühlleistungen an unterschiedlichen Kühlplattensegmenten 43 realisiert werden. Insbesondere kann hierzu eine Kühlplatte 7 in Querrichtung 17 und/oder Längsrichtung 15 und/oder Vertikalrichtung 16 in Kühlplattensegmente 43 unterteilt sein.

Zur Erleichterung des Austauschs einer Leistungsbaugruppe 1 hat es sich als vorteilhaft erwiesen, wenn die Kühlplatte 7 im Stützbereich 12 durch Rollkörper 27 oder nicht dargestellte Gleitelemente am Gestell 3 abgestützt wird. In den Fig. 6 und 7 sind beispielhafte mögliche Ausführungsformen unterschiedlicher Rollkörperanordnungen und/oder Anhebe- und Bewegungsmechanismen dargestellt.

Im einfachsten, nicht dargestellten Fall sind zumindest zwei Rollkörper 27 starr an zumindest einem Stützbereich 12 angeordnet und erleichtern die Bewegung in Längsrichtung 15. Die Anordung der Rollkörper 27 kann dabei an oder innerhalb der Kühlplatte 7 erfolgen, oder in einer dafür vorgesehenen, nicht eigens dargestellten, Rollkörperaufnahme welche den Lastabtrag der Leistungsbaugruppe 1 über die Kühlplatte 7 bzw. deren Stützbereich 12 sicherstellt.

In Fig. 6a und b ist eine mögliche Anordnung von verstellbaren Rollkörpern 27 in einer Servicestellung 31 bzw. Ruhestellung 32 dargestellt. Die Rollkörper 27 sind in einem Stützbereich 12 in Richtung Unterseite gegenüber der Stützfläche 19 hervorragbar gelagert. Das Wirkprinzip dieses relativ einfachen Hebemechanismus ist beispielhaft an einem Rollkörper 27 gezeigt. Die Hebelvorrichtung 45 verbindet den Rollkörper 27 mit einer Schubstange 46, welche mit zumindest einem zweiten Rollkörper 27, und im Falle von mehreren Rollkörpern 27, bevorzugt mit allen Rollkörpern 27, gekoppelt ist. Diese Anordnung kann seitlich oder auch innerhalb der Kühlplatte 7 angeordnet sein. In Fig. 6a ist der Rollkörper 27 in der Ruhestellung 32 vollständig hinter die Stützfläche 19 zurückgetreten. Auf diese Weise kann die Leistungsbaugruppe 1 auf den Stützbereich 12 bzw. die Stützfläche 19 am Gestell 3 abgestützt und somit ruhend gelagert werden. Durch Einwirkung einer Kraft, welche als Bewegungspfeil in Fig. 6b dargestellt ist, erfolgt eine Bewegung der Schubstange 46 in Längsrichtung 15, wodurch der Rollkörper 27 über die Ebene der Stützfläche 19 hervortritt und die Leistungsbaugruppe 1 wenige Millimeter bis Zentimeter angehoben werden kann. Auf diese Weise kann die Ausbildung von Rollkörpern 27 als integraler Bestandteil des Stützbereichs 12 und/oder der Kühlplatte 7 zu einem kraftsparenden Austausch der Leistungsbaugruppe 1 verwendet werden.

In Fig. 7a ist schematisch eine Situation angedeutet, in welcher zumindest zwei Rollkörper 27 im Stützbereich 12 im Bereich der Kühlplattenoberseite 11 angeordnet sind. In der beispielhaften Darstellung sind die Rollkörper 27 beidseitig an der Kühlplatte angeordnet, obwohl auch eine einseitige Anordnung denkbar ist. Ferner ist aus der Darstellung ersichtlich, dass das Führungselement 22 im Bereich der Kühlplattenoberseite 11 als zum Beispiel C-förmiges Profilelement ausgebildet ist und zur Aufnahme der Rollkörper 27 dient, wodurch eine Art hängende Anordnung der Leistungsbaugruppe 1 ermöglicht wird. Gleichermaßen kann durch eine derartige Anordnung der Rollkörper 27 die Lagestabilität der Leistungsbaugruppe 1 weitestgehend unabhängig von einer erhöhten Schwerpunktlage gemacht werden.

Aus Fig. 7a kann eine alternative mögliche Anordnung von Rollkörpern 27 im Stützbereich 12 ersehen werden, wobei die zumindest zwei Rollkörper 27 im Bereich der Kühlplattenunterseite angeordnet sind und zur Abstützung der Stützfläche 19 genutzt werden. Eine derartige Anordnung kann alleine oder auch in Kombination mit Rollkörpern 27, welche im Stützbereich 12 an der Kühlplattenoberseite 11 angeordnet sind, ausgebildet werden.

Fig. 7b stellt eine alternative und für sich eigenständige Möglichkeit zur Anordnung zumindest zweier Rollkörper 27 in zumindest einem Stützbereich 12 dar. Die Schnittdarstellung zeigt einen Rollkörper 27 dessen Rotationsachse im Wesentlichen in Vertikalrichtung 16 ausgerichtet ist, im Bereich der Kühlplattenoberseite 11. Hierbei findet im Wesentlichen eine seitliche Abstützung der Kühlplatte in Querrichtung 17 an den dafür vorgesehenen Führungselementen 22 statt. Um ein Blockieren des Rollkörpers 27 zu vermeiden sollte ein geringfügiger Luftspalt vorgesehen werden. Alternativ kann auch die Ausbildung eines Gleitelements im oberen Stützbereich 12 angedacht sein. In beiden Fällen kann jedoch die Ausbildung von Rollkörpern 27 und/oder Gleitelementen an der Unterseite der Kühlplatte 7 erforderlich machen. Eine mögliche Ausführungsform hierfür ist in Fig. 7b im Bereich der Unterseite der Kühlplatte dargestellt, wobei ein Hebewerkzeug 30 in den Längsträger 26 eingeführt ist und über zumindest zwei Rollkörper 27 verfügt.

Die Rollkörper 27 eines derartigen, in einen Längsträger 26 des Gestells 3 einführbaren, Hebewerkzeugs 30 sind analog zur Beschreibung der verstellbaren Rollkörper 27 in Fig. 6a und b verstellbar ausgebildet. In der Darstellung 7b ist analog zur Fig. 6b der Rollkörper 27 in der Servicestellung 31 dargestellt. Zur Verdeutlichung sei auf Fig. 7c verwiesen, worin ein in einen Längsträger 26 einführbares Hebewerkzeug 30 in einer Schrägansicht besser ersichtlich ist. Ein derartiges Hebewerkzeug 30 weist zumindest zwei verstellbare Rollkörper 27 auf, welche analog jedoch in umgekehrte Wirkrichtung zum beschriebenen Funktionsprinzip der Diskussion von Fig. 6 auf. Um den Durchtritt der Rollkörper 27 des eingeführten Hebewerkzeugs 30 durch die Oberseite eines Längsträgers 26 zu ermöglichen, sind Durchtrittsöffnungen 29 vorgesehen. Der Längsträger 26 ist als Hohlkörper 28 ausgebildet. Die gemeinsame Verstellung der Rollkörper 27 eines externen Hebewerkzeugs 30 kann manuell oder auch motorisch durchgeführt werden. Wie eine Zusammenschau, insbesondere mit Fig. 1 zeigt, kann ein derartiges Hebewerkzeug 30 für sämtliche Leistungsbaugruppen 1 eines Mittel- oder Hochspannungsumrichters 2 verwendet werden. Außerdem kann durch ein solches Hebewerkzeug 30 die Ausbildung integraler Rollkörper 27 an und/oder innerhalb der Kühlplatte 7 vermieden werden.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

**Bezugszeichenaufstellung**

| | | | |
|---|---|---|---|
| 1 | Leistungsbaugruppe | 30 | Hebewerkzeug |
| 2 | Mittel- oder Hochspannungsumrichter | 31 | Servicestellung |
| | | 32 | Ruhestellung |
| 3 | Gestell | 33 | Stromanschluss |
| 4 | Leistungshalbleiterbaugruppe | 34 | Messanschluss |
| 5 | Energiespeicherbaugruppe | 35 | Hilfsanschluss |
| 6 | Kühlvorrichtung | 36 | Steueranschluss |
| 7 | Kühlplatte | 37 | Kühlmittelanschluss |
| 8 | Kühlplattenlänge | 38 | Koppelvorrichtung |
| 9 | Kühlplattenhöhe | 39 | Rückhalteelement |
| 10 | Kühlplattendicke | 40 | Schutzgehäuse |
| 11 | Kühlplattenoberseite | 41 | Frontseite |
| 12 | Stützbereich | 42 | Anschlagelement |
| 13 | erste Seite | 43 | Kühlplattensegment |
| 14 | zweite Seite | 44 | Kühlkanal |
| 15 | Längsrichtung | 45 | Hebelvorrichtung |
| 16 | Vertikalrichtung | 46 | Schubstange |
| 17 | Querrichtung | 47 | Rückseite |
| 18 | Aufnahmefläche | 48 | Schottwandelement |
| 19 | Stützfläche | | |
| 20 | Anschlussöffnung | | |
| 21 | Hilfsbaugruppe | | |
| 22 | Führungselement | | |
| 23 | Aufnahmeraum | | |
| 24 | Vertikalsteher | | |
| 25 | Horizontalträger | | |
| 26 | Längsträger | | |
| 27 | Rollkörper | | |
| 28 | Hohlkörper | | |
| 29 | Durchtrittsöffnung | | |

## Patentansprüche

1. Leistungsbaugruppe (1) für einen Mittel- oder Hochspannungsumrichter (2), vorzugsweise einen Modularen Multilevel Umrichter, umfassend,
- zumindest eine Leistungshalbleiterbaugruppe (4)
- zumindest eine Energiespeicherbaugruppe (5),
- zumindest eine Kühlvorrichtung (6), wobei
- die Kühlvorrichtung (6) als, von einem Kühlmittel durchströmbare, insbesondere einer Kühlflüssigkeit durchfließbare, Kühlplatte (7) ausgebildet ist, welche eine verglichen zu einer Kühlplattenlänge (8) und einer Kühlplattenhöhe (9) geringere Kühlplattendicke (10) aufweist, und die Kühlplatte (7) zum Lastabtrag der Leistungsbaugruppe (1) auf ein Gestell (3) des Mittel- oder Hochspannungsumrichters (2) zumindest einen, durch die Kühlplattenlänge (8) und Kühlplattendicke (10) und/oder einem Teil der Kühlplattenhöhe (9) der Kühlplatte (7) definierten, Stützbereich (12) aufweist,
**dadurch gekennzeichnet, dass**
die Kühlplatte (7) an beiden, durch die Kühlplattenlänge (8) und die Kühlplattenhöhe (9) der Kühlplatte (7) definierte, Seiten (13, 14) zumindest eine Aufnahmefläche (18), zur Anordnung jeweils zumindest einer Leistungshalbleiterbaugruppe (4) oder zumindest einer Energiespeicherbaugruppe (5), aufweist,
wobei die zumindest eine Leistungshalbleiterbaugruppe (4) an der ersten Seite (13) und die zumindest eine Energiespeicherbaugruppe (5) an der, der ersten Seite (13) gegenüberliegenden, zweiten Seite (14) der Kühlplatte (7) angeordnet sind.

2. Leistungsbaugruppe (1) nach Anspruch 1 **dadurch gekennzeichnet, dass** der zumindest eine Stützbereich (12) zum abstützenden Lastabtrag auf das Gestell (3) in Vertikalrichtung im Wesentlichen nach unten als Stützfläche (19), bevorzugt zumindest die Kühlplattenlänge (8) und Kühlplattendicke (10) umfassend, ausgebildet ist.

3. Leistungsbaugruppe (1) nach Anspruch 1 oder 2 **dadurch gekennzeichnet, dass** der zumindest eine Stützbereich (12) zum Lastabtrag auf das Gestell (3) im Bereich einer Kühlplattenoberseite (11) der Kühlplatte (7), bevorzugt umfassend zumindest die Kühlplattenlänge (8) und einen Teil der Kühlplattenhöhe (9), ausgebildet ist.

4. Leistungsbaugruppe (1) nach Anspruch 1 **dadurch gekennzeichnet, dass** die Kühlplatte (7) zumindest eine Anschlussöffnung (20) in Querrichtung (17) zur Durchführung und Kontaktierung zumindest von Stromanschlüssen (33) der zumindest einen Energiespeicherbaugruppe (5) zur zumindest einen Leistungshalbleiterbaugruppe (4) und/oder zumindest einer Hilfsbaugruppe (21) aufweist.

5. Leistungsbaugruppe (1) nach einem der vorhergehenden Ansprüche **dadurch gekennzeichnet, dass** an der Kühlplatte (7) zumindest ein mit einer Koppelvorrichtung (38) des Gestells (3) korrespondierendes, Rückhalteelement (39) angeordnet ist.

6. Leistungsbaugruppe (1) nach einem der vorhergehenden Ansprüche **dadurch gekennzeichnet, dass** die Leistungsbaugruppe (1) zumindest ein Schutzgehäuse (40) zur Aufnahme zumindest einer Leistungshalbleiterbaugruppe (4) und/oder Hilfsbaugruppe (21) und/oder Energiespeicherbaugruppe (5) aufweist, welches mit der Kühlplatte (7) befestigbar, bevorzugt koppelbar, ausgebildet ist.

7. Leistungsbaugruppe (1) nach Anspruch 6 **dadurch gekennzeichnet, dass** zumindest ein Schottwandelement (48) zumindest zwei Komponenten, wie etwa Leistungshalbleiterbaugruppe (4) und/oder der Hilfsbaugruppe (21) und/oder der Energiespeicherbaugruppe (5), voneinander trennend, sowie die Kühlplatte (7) mit dem zumindest einen Schutzgehäuse (40) verbindend angeordnet ist.

8. Leistungsbaugruppe (1) nach einem der vorhergehenden Ansprüche **dadurch gekennzeichnet, dass** zumindest zwei Stromanschlüsse (33) und/oder Steueranschlüsse (36) und/oder, Kühlmittelanschlüsse (37) und/oder etwaige Messanschlüsse (34) und/oder Hilfsanschlüsse (35) an einer Frontseite (41) der Leistungsbaugruppe (1) ausgebildet sind.

9. Leistungsbaugruppe (1) nach einem der vorhergehenden Ansprüche **dadurch gekennzeichnet, dass** zumindest zwei Stromanschlüsse (33) und/oder Steueranschlüsse (36) und/oder, bevorzugt als Schnellverschlüsse ausgebildete, Kühlmittelanschlüsse (37) und/oder etwaige Messanschlüsse (34) und/oder Hilfsanschlüsse (35) an einer Rückseite (47) der Leistungsbaugruppe (1) ausgebildet sind.

10. Leistungsbaugruppe (1) nach einem der vorhergehenden Ansprüche **dadurch gekennzeichnet, dass** die Kühlplatte (7) aus zumindest zwei in Längsrichtung (15) und/oder Querrichtung (17) und/oder Vertikalrichtung (16) geteilten, Kühlplattensegmenten (43) zur Ausbildung eines durchgehenden Kühlkanals (44) zusammengesetzt ist.

11. Leistungsbaugruppe (1) nach Anspruch 10 **dadurch gekennzeichnet, dass** zumindest zwei Kühlplattensegmente (43) voneinander unterschiedliche Kühlleistungen aufweisen.

12. Leistungsbaugruppe (1) nach einem der vorhergehenden Ansprüche **dadurch gekennzeichnet, dass** die Kühlplatte (7) zumindest in Vertikalrichtung (16) relativ zur zumindest einen Leistungshalbleiterbaugruppe (4) und/oder zumindest einen Energiespeicherbaugruppe (5) und/oder zumindest einem Schutzgehäuse (40) hervorragend ausgebildet ist.

13. Leistungsbaugruppe (1) nach einem der vorhergehenden Ansprüche **dadurch gekennzeichnet, dass** im Stützbereich (12) zumindest zwei Rollkörper (27) an der Kühlplatte (7) oder einer dafür vorgesehenen Rollkörperaufnahme ausgebildet sind.

14. Mittel- oder Hochspannungsumrichter (2), vorzugsweise einen Modularen Multilevel Umrichter, umfassend
- zumindest eine Leistungsbaugruppe (1) nach einem der Ansprüche 1 bis 13,
- ein Gestell (3) mit einer Mehrzahl von Vertikalstehern (24) und Horizontalträgern (25), welche zur Verbindung jeweils zumindest zweier Vertikalsteher (24) angeordnet sind, und welches Gestell (3) zumindest einen Aufnahmeraum (23) für zumindest eine Leistungsbaugruppe (1) aufweist,
**dadurch gekennzeichnet, dass**
zumindest ein Längsträger (26) zum Lastabtrag der Leistungsbaugruppe (1) zumindest zwei Horizontalträgern (25) verbindend angeordnet ist.

15. Mittel- oder Hochspannungsumrichter (2) nach Anspruch 14 **dadurch gekennzeichnet, dass** zumindest ein Horizontalträger (25) und/oder Längsträger (26) aus einem elektrisch isolierenden Werkstoff, bevorzugt einem Glasfaserverbundwerkstoff, hergestellt sind.

16. Mittel- oder Hochspannungsumrichter (2) nach einem der Ansprüche 14 oder 15 **dadurch gekennzeichnet, dass** zumindest ein Längsträger (26) als Hohlkörper (28) ausgebildet ist und zumindest zwei Durchtrittsöffnungen (29), zum Durchtritt jeweils zumindest eines Rollkörpers (27) in einer Servicestellung (31) eines in den Längsträger (26) in einer Ruhestellung (32) einführbaren Hebewerkzeugs (30), aufweist.

17. Mittel- oder Hochspannungsumrichter (2) nach Anspruch 14 bis 16 **dadurch gekennzeichnet, dass** zumindest ein Längsträger (26) zumindest ein Führungselement (22) zur Führung der Kühlplatte (7), insbesondere des Stützbereichs (12), zumindest in Querrichtung (17) aufweist.

18. Mittel- oder Hochspannungsumrichter (2) nach einem der Ansprüche 14 bis 17 **dadurch gekennzeichnet, dass** zumindest ein Führungselement (22) zur Aufnahme des Stützbereichs (12) und/oder Führung der Kühlplatte (7) an einer Unterseite zumindest eines Längsträgers (26) als Z-, L-, C- oder U-förmiges Profilelement ausgebildet ist.

## Claims

1. A power module (1) for a medium or high voltage converter (2), preferably a modular multilevel converter, comprising
- at least one power semiconductor module (4),
- at least one energy storage module (5),
- at least one cooling device (6), wherein
- the cooling device (6) is formed as a cooling plate (7) which can be run through by a coolant, in particular flown through by a cooling liquid, and which has a smaller cooling plate thickness (10) as compared to a cooling plate length (8) and a cooling plate height (9),
and the cooling plate (7) has at least one support region (12) defined by the cooling plate length (8) and the cooling plate thickness (10) and/or a part of the cooling plate height (9) of the cooling plate (7), for load transfer of the power module (1) onto a rack (3) of the medium or high voltage converter (2),
**characterized in that**
the cooling plate (7) has at least one receiving surface (18) on both sides (13, 14) defined by the cooling plate length (8) and the cooling plate height (9) of the cooling plate (7), for arranging at least one power semiconductor module (4) or at least one energy storage module (5) each,
wherein the at least one power semiconductor module (4) is arranged on the first side (13), and the at least one energy storage module (5) is arranged on the second side (14) of the cooling plate (7) opposite the first side (13).

2. The power module (1) according to claim 1, **characterized in that** the at least one support region (12) for the supporting load transfer onto the rack (3), substantially downward in the vertical direction, is designed as a support surface (19), preferably comprising at least the cooling plate length (8) and cooling plate thickness (10).

3. The power module (1) according to claim 1 or 2, **characterized in that** the at least one support region (12) for the load transfer onto the rack (3) is formed in the region of an upper side (11) of the cooling plate (7), preferably comprising at least the cooling plate length (8) and a part of the cooling plate height (9).

4. The power module (1) according to claim 1, **characterized in that** the cooling plate (7) comprises at least one connection opening (20) in a transverse direction (17) for leading through and contacting at least electrical connections (33) of the at least one energy storage module (5) to the at least one power semiconductor module (4) and/or at least one auxiliary module (21).

5. The power module (1) according to one of the preceding claims, **characterized in that** at least one retaining element (39) corresponding with a coupling device (38) of the rack (3) is arranged on the cooling plate (7).

6. The power module (1) according to one of the preceding claims, **characterized in that** the power module (1) has at least one protective housing (40) for accommodating at least one power semiconductor module (4) and/or auxiliary module (21) and/or energy storage module (5), which protective housing is designed so as to be affixable, preferable couplable, to the cooling plate (7).

7. The power module (1) according to claim 6, **characterized in that** at least one bulkhead partition element (48) is arranged so as to separate at least two components such as the power semiconductor module (4) and/or the auxiliary module (21) and/or the energy storage module (5), and so as to connect the cooling plate (7) to the at least one protective housing (40).

8. The power module (1) according to one of the preceding claims, **characterized in that** at least two electrical connections (33) and/or control connections (36) and/or coolant connections (37) and/or possible measuring connections (34) and/or auxiliary connections (35) are formed on a front side (41) of the power module (1).

9. The power module (1) according to one of the preceding claims, **characterized in that** at least two electrical connections (33) and/or control connections (36) and/or coolant connections (37), preferably formed as quick-release connectors, and/or possible measuring connections (34) and/or auxiliary connections (35) are formed on a rear side (47) of the power module (1).

10. The power module (1) according to one of the preceding claims, **characterized in that** the cooling plate (7) is assembled of at least two cooling plate segments (43) divided in the longitudinal direction (15) and/or the transverse direction (17) and/or the vertical direction (16), for the formation of a continuous coolant channel (44).

11. The power module (1) according to claim 10, **characterized in that** at least two cooling plate segments (43) have different cooling capacities.

12. The power module (1) according to one of the preceding claims, **characterized in that** the cooling plate (7) is designed so as to protrude in a vertical direction (16) relative to the at least one power semiconductor module (4) and/or the at least one energy storage module (5) and/or the at least one protective housing (40).

13. The power module (1) according to one of the preceding claims, **characterized in that**, in the support region (12), at least two rolling bodies (27) are formed on the cooling plate (7) or on a rolling body receptacle provided for this purpose.

14. A medium or high voltage converter (2), preferably a modular multilevel converter, comprising
- at least one power module (1) according to one of claims 1 to 13,
- a rack (3) having a plurality of vertical standing members (24) and horizontal beams (25), which are arranged for connecting to at least two vertical standing members (24) each, and which rack (3) has at least one receiving space (23) for at least one power module (1),
**characterized in that**
at least one longitudinal beam (26) is arranged so as to connect at least two horizontal beams (25) for the load transfer of the power module (1).

15. The medium or high voltage converter (2) according to claim 14, **characterized in that** at least one horizontal beam (25) and/or longitudinal beam (26) are made from an electrically insulating material, preferably a glass fiber composite material.

16. The medium or high voltage converter (2) according to one of claims 14 or 15, **characterized in that** at least one longitudinal beam (26) is configured as a hollow body (28) and has at least two passages (29) for the passage, in each case, of at least one rolling body (27) in a service position (31) and one lifting tool (30) insertable into the longitudinal beam (26) in a rest position (32).

17. The medium or high voltage converter (2) according to claim 14 to 16, **characterized in that** at least one longitudinal beam (26) comprises at least one guide element (22) for guiding the cooling plate (7), in particular the support region (12), at least in the transverse direction (17).

18. The medium or high voltage converter (2) according to one of claims 14 to 17, **characterized in that** at least one guide element (22) is configured as a Z-shaped, L-shaped, C-shaped or U-shaped profile element on a bottom side of at least one longitudinal beam (26) for accommodating the support region (12) and/or guiding the cooling plate (7).

## Revendications

1. Module de puissance (1) pour un convertisseur moyenne tension ou haute tension (2), de préférence un convertisseur modulaire multi-niveaux, comprenant
- au moins un module de puissance semi-conducteur (4)
- au moins un module accumulateur d'énergie (5),
- au moins un dispositif de refroidissement (6) dans lequel
- le dispositif de refroidissement (6) est conçu comme une plaque de refroidissement (7) traversée par un produit de refroidissement, plus particulièrement un liquide de refroidissement, qui présente une épaisseur de plaque de refroidissement (10) très faible par rapport à une longueur de plaque de refroidissement (8) et à une hauteur de plaque de refroidissement (9), et la plaque de refroidissement (7) comprend, pour le support du module de puissance (1) sur un châssis (3) du convertisseur moyenne tension ou haute tension (2), au moins une zone d'appui (12) définie par la longueur de plaque de refroidissement (8) et l'épaisseur de plaque de refroidissement (10) et/ou une partie de la hauteur de plaque de refroidissement (9) de la plaque de refroidissement (7), **caractérisé en ce que**
la plaque de refroidissement (7) comprend, sur deux côtés (13, 14), définis par la longueur de plaque de refroidissement (8) et la hauteur de plaque de refroidissement (9) de la plaque de refroidissement (7), au moins une surface de logement (18) pour la disposition de respectivement au moins un module semi-conducteur de puissance (4) ou d'au moins un module accumulateur d'énergie (5),
dans lequel l'au moins un module semi-conducteur de puissance (4) est disposé sur le premier côté (13) et l'au moins un module accumulateur d'énergie (5) est disposé sur le deuxième côté (14), opposé au premier côté (13), de la plaque de refroidissement (7).

2. Module de puissance (1) selon la revendication 1, **caractérisé en ce que** l'au moins une zone d'appui (12) est conçue pour le support sur le châssis (3) dans la direction verticale globalement vers le bas en tant que surface d'appui (19), de préférence comprenant au moins la longueur de plaque de refroidissement (8) et l'épaisseur de plaque de refroidissement (10).

3. Module de puissance (1) selon la revendication 1 ou 2, **caractérisé en ce que** l'au moins une zone d'appui (12) est conçue pour le support sur le châssis (3) au niveau d'un côté supérieur de plaque de refroidissement (11) de la plaque de refroidissement (7), comprenant de préférence au moins la longueur de plaque de refroidissement (8) et une partie de l'épaisseur de plaque de refroidissement (9).

4. Module de puissance (1) selon la revendication 1, **caractérisé en ce que** la plaque de refroidissement (7) comprend au moins une ouverture de raccordement (20) dans la direction transversale (17) pour le passage et la mise en contact au moins de raccordements électriques (33) de l'au moins un module accumulateur d'énergie (5) avec au moins un module semi-conducteur de puissance (4) et/ou au moins un module auxiliaire (21).

5. Module de puissance (1) selon l'une des revendications précédentes, **caractérisé en ce que**, sur la plaque de refroidissement (7), est disposé au moins un élément de retenue (39) correspondant à un dispositif de couplage (38) du châssis (3).

6. Module de puissance (1) selon l'une des revendications précédentes, **caractérisé en ce que** le module de puissance (1) comprend au moins un boîtier de protection (40) pour le logement d'au moins un module semi-conducteur de puissance (4) et/ou au moins un module auxiliaire (21) et/ou au moins un module accumulateur d'énergie (5), qui est conçu pour être fixé, de préférence couplé, à la plaque de refroidissement (7).

7. Module de puissance (1) selon la revendication 6, **caractérisé en ce qu'**au moins un élément de cloison (48) est disposé de façon à séparer au moins deux composants tels que le module semi-conducteur de puissance (4) et/ou le module auxiliaire (21) et/ou le module accumulateur d'énergie (5) et la plaque de refroidissement (7) est disposée de façon à être reliée avec l'au moins un boîtier de protection (40).

8. Module de puissance (1) selon l'une des revendications précédentes, **caractérisé en ce qu'**au moins deux raccordements électriques (33) et/ou raccordements de commande (36) et/ou des raccords de produit de refroidissement (37) et/ou d'éventuels raccords de mesure (34) et/ou des raccords auxiliaires (35), sont prévus sur un côté frontal (41) du module de puissance (1).

9. Module de puissance (1) selon l'une des revendications précédentes, **caractérisé en ce qu'**au moins deux raccordements électriques (33) et/ou raccordements de commande (36), conçus de préférence comme des raccords rapides, des raccords de produit de refroidissement (37) et/ou d'éventuels raccords de mesure (34) et/ou des raccords auxiliaires (35), sont prévus sur un côté arrière (47) du module de puissance (1).

10. Module de puissance (1) selon l'une des revendications précédentes, **caractérisé en ce que** la plaque de refroidissement (7) est constituée d'au moins deux segments de plaque de refroidissement (43), divisés dans la direction longitudinale (15) et/ou dans la direction transversale (17) et/ou la direction verticale (16), pour la formation d'un canal de refroidissement traversant (44).

11. Module de puissance (1) selon la revendication 10, **caractérisé en ce qu'**au moins deux segments de plaque de refroidissement (43) présentent des puissances de refroidissement différentes entre elles.

12. Module de puissance (1) selon l'une des revendications précédentes, **caractérisé en ce que** la plaque de refroidissement (7) est conçue de façon à dépasser, au moins dans la direction verticale (16), par rapport à l'au moins un module semi-conducteur de puissance (4) et/ou à l'au moins un module accumulateur d'énergie (5) et/ou à l'au moins un boîtier de protection (40).

13. Module de puissance (1) selon l'une des revendications précédentes, **caractérisé en ce que**, dans la zone d'appui (12), sont prévus au moins deux corps de roulement (27) sur la plaque de refroidissement (7) au niveau d'un logement de corps de roulement prévu à cet effet.

14. Convertisseur moyenne tension ou haute tension (2), de préférence convertisseur modulaire multi-niveaux, comprenant
- au moins un module de puissance (1) selon l'une des revendications 1 à 13,
- un châssis (3) avec une pluralité de montants verticaux (24) et supports horizontaux (25) qui sont disposés afin de relier chacun au moins deux montants verticaux (24), et ce châssis (3) comprenant au moins un espace de logement (23) pour au moins un module de puissance (1),
**caractérisé en ce que**
au moins un support longitudinal (26) est disposé de façon à relier au moins deux supports horizontaux (25) pour le support de la charge du module de puissance (1).

15. Convertisseur moyenne tension ou haute tension (2) selon la revendication 14, **caractérisé en ce qu'**au moins un support horizontal (25) et/ou support longitudinal (26) est constitué d'un matériau électriquement isolant, de préférence un composite à base de fibre de verre.

16. Convertisseur moyenne tension ou haute tension (2) selon l'une des revendications 14 ou 15, **caractérisé en ce qu'**au moins un support longitudinal (26) est conçu comme un corps creux (28) et comprend au moins deux ouvertures de passage (29), chacun pour le passage d'au moins un corps de roulement (27) dans une position de maintenance (31) d'un dispositif de levage (30) pouvant être inséré dans les supports longitudinaux (26), dans une position de repos (32).

17. Convertisseur moyenne tension ou haute tension (2) selon l'une des revendications 14 à 16, **caractérisé en ce qu'**au moins un support longitudinal (26) comprend au moins un élément de guidage (22) pour le guidage de la plaque de refroidissement (7), plus particulièrement de la zone d'appui (12), au moins dans la direction transversale (17).

18. Convertisseur moyenne tension ou haute tension (2) selon l'une des revendications 14 à 17, **caractérisé en ce qu'**au moins un élément de guidage (22) est conçu pour le logement de la zone d'appui (12) et/ou le guidage de la plaque de refroidissement (7) sur un côté inférieur d'au moins un support longitudinal (26), sous la forme d'un élément profilé en forme de Z, de L, de C ou de U.
